# EUROPÄISCHE PATENTSCHRIFT

(11) **EP 1 597 774 B1**
(45) Veröffentlichungstag und Bekanntmachung des Hinweises auf die Patenterteilung: **14.03.2007**
(21) Anmeldenummer: 03735418.0
(22) Anmeldetag: 19.05.2003
(51) Int. Cl.: H01L 31/173, H01L 51/50

(54) **OPTOELEKTRONISCHES BAUELEMENT MIT EINER LEUCHTDIODE UND EINER MEHRZAHL VON LICHTSENSOREN**
OPTOELECTRONIC COMPONENT COMPRISING A LIGHT EMITTING DIODE AND A PLURALITY OF LIGHT SENSORS
COMPOSANT OPTOÉLECTRONIQUE COMPORTANT UNE DIODE LUMINESCENTE ET UNE PLURALITÉ DE CAPTEURS DE LUMIÈRE

(43) Veröffentlichungstag der Anmeldung: 23.11.2005
(73) Patentinhaber: Fraunhofer-Gesellschaft zur Förderung der angewandten Forschung e.V., 80686 München (DE)
(72) Erfinder: GRÜGER, Heinrich, 01109 Dresden (DE); SCHNEIDER, Torsten, 01877 Putzham (DE); AMELUNG, Jörg, 01099 Dresden (DE); SAUER, Bodo, 01689 Weinböhla (DE)
(74) Vertreter: Schoppe, Fritz
(86) Internationale Anmeldenummer: PCT/EP2003/005253
(87) Internationale Veröffentlichungsnummer: WO 2004/102681

(56) Entgegenhaltungen:
- EP-A- 1 096 466
- WO-A-99/54936
- US-A- 5 629 533
- US-A1- 2001 052 597
- US-A1- 2002 027 206
- US-B1- 6 320 325
- PATENT ABSTRACTS OF JAPAN vol. 018, no. 684 (E-1650), 22. Dezember 1994 (1994-12-22) & JP 06 275864 A (MITSUI TOATSU CHEM INC), 30. September 1994 (1994-09-30)
- PATENT ABSTRACTS OF JAPAN vol. 2000, no. 24, 11. Mai 2001 (2001-05-11) & JP 2001 203078 A (TDK CORP), 27. Juli 2001 (2001-07-27)

## Beschreibung

Die vorliegende Erfindung bezieht sich auf ein optoelektronisches Bauelement mit einer Leuchtdiode und einer Mehrzahl von Lichtsensoren, die insbesondere zur Erfassung einer Weglänge, eines Drehwinkels, eines Abstands oder einer Position verwendbar sind.

Auf zahlreichen Gebieten der Technik werden optoelektronische Bauelemente bzw. Systeme verwendet, um Abstände, Wegstrecken, Drehwinkel, Positionen und andere Größen zu erfassen. Dazu werden insbesondere optoelektronische Bauelemente verwendet, die eine Lichtquelle bzw. Strahlungsquelle und einen Lichtsensor bzw. einen lichtempfindlichen Detektor umfassen.

Von der Lichtquelle emittiertes Licht wird von einem optischen Bauelement auf den Lichtsensor gelenkt. Das optische Bauelement ist beispielsweise ein Reflektor, ein Spiegel oder ein anderes reflektierendes Bauelement, ein optisches Gitter oder eine andere lichtbeugende Einrichtung. Die Intensität des von dem Lichtsensor empfangenen Lichts ist vom Abstand des optischen Bauelements von dem optoelektronischen Bauelement oder von seiner räumlichen Orientierung abhängig. Aus dem durch den Lichtsensor empfangenen Licht kann deshalb auf den Abstand, den Ort oder die räumliche Orientierung des optischen Bauelements relativ zu dem optoelektronischen Bauelement geschlossen werden.

Bei manchen Anwendungen wird kein optisches Bauelement verwendet, sondern das von der Leuchtdiode emittierte Licht wird von einem zu erfassenden Gegenstand reflektiert. Von dem von den Lichtsensor empfangenen reflektierten Licht kann auf Ort, Anordnung, Größe oder andere Eigenschaften des Gegenstands geschlossen werden. Ein Beispiel ist die "Out of Position"-Detektion eines Beifahrers in einem Kraftfahrzeug in Bezug zu einem Airbag.

Als Lichtsensoren werden häufig Photodioden, Phototransistoren, Photowiderstände oder ähnliche Halbleiterbauelemente verwendet. Anstelle eines einzelnen Lichtsensors werden häufig mehrere Lichtsensoren verwendet, die eindimensional als Zeile oder zweidimensional als Array angeordnet sein können. Die Verwendung mehrerer Lichtsensoren ermöglicht eine Erfassung von einfachen geometrischen Abbildungen oder auch von Beugungs- oder Interferenz-Mustern.

Als Lichtquellen werden häufig lichtemittierende Dioden bzw. Leuchtdioden (LED; LED = Light Emitting Diode) verwendet. Um Licht, das von der Lichtquelle emittiert und auf den Lichtsensor gelenkt wird, von Licht anderer Herkunft zu unterscheiden, emittiert die Lichtquelle häufig eine charakteristische Signatur bzw. ein Lichtsignal mit einer Zeitabhängigkeit, die einer dem Lichtsensor nachgeschalteten Auswerteelektronik bekannt ist.

Die technologisch einfachste und anspruchloseste Realisierung eines optoelektronischen Bauelementes mit einem Lichtsensor und einer Lichtquelle ist der Aufbau der entsprechenden Geber- und Detektor-Strukturen aus diskreten Bauelementen auf einer Platine. Fertigungstechnisch ist diese Realisierung jedoch sehr aufwendig. Ferner ist eine Miniaturisierung auch bei Verwendung von oberflächenmontierten Bauelementen nur eingeschränkt möglich.

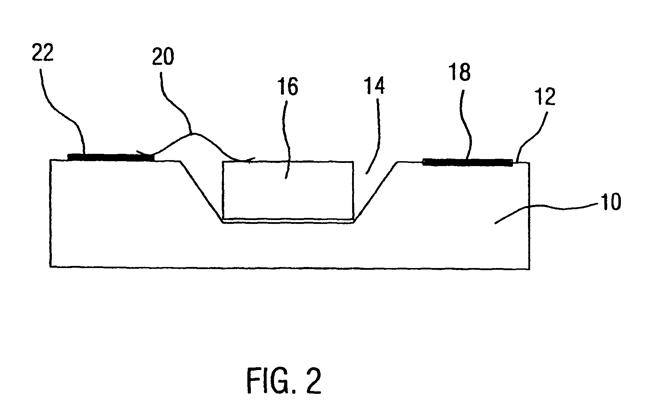

Insbesondere in größerer Stückzahl herzustellende oder stärker miniaturisierte optoelektronische Bauelemente werden deshalb in der Regel mit einer Anordnung realisiert, wie sie in der DE 19720300 A1 beschrieben ist. Diese Anordnung ermöglicht ein deutlich kleineres optoelektronisches Bauelement, das mit geringerem Aufwand montierbar ist. Fig. 2 ist eine schematische Darstellung eines Schnitts durch ein optoelektronisches Bauelement, wie es in der DE 19720300 beschrieben ist. Ein Si-Substrat bzw. Chip 10 weist an einer Oberfläche 12 eine Vertiefung bzw. Ausnehmung 14 auf. In der Ausnehmung 14 ist eine SMD-Leuchtdiode 16 als Lichtquelle des optoelektronischen Bauelements angeordnet. An der Oberfläche des Substrats 10 ist außerhalb der Ausnehmung 14 eine Mehrzahl von lichtempfindlichen Dioden 18 als Lichtsensoren angeordnet. Die SMD-Leuchtdiode 16 und die lichtempfindlichen Dioden 18 sind mit Leiterbahnen verbunden bzw. durch Leiterbahnen kontaktiert, um elektrische Signale zuzuführen und abzugreifen. Die SMD-Leuchtdiode 16 ist über einen oder mehrere Bonddrähte 20 mit einer Leiterbahn 22 verbunden.

Ein Nachteil des Anhand der Fig. 2 dargestellten herkömmlichen optoelektronischen Bauelements ist, daß die Erzeugung der Grube bzw. Ausnehmung 14 besondere bzw. zusätzliche Prozeßschritte erfordert. Dies erhöht die Herstellungskosten und wie jeder Prozeßschritt die Wahrscheinlichkeit eines Defekts und damit den Ausschuß der Produktion. Ein weiterer Nachteil ist, daß eine Metallisierung bzw. die Erzeugung einer Leiterbahn in der Ausnehmung 14, beispielsweise zur Kontaktierung der dem Si-Substrat 10 zugewandten Seite der SMD-Leuchtdiode 16, kritisch ist. Ferner ist die Anforderung an die Präzision bei der Montage der SMD-Leuchtdiode 16 in der Ausnehmung 14 hoch. Der oder die zur Kontaktierung der SMD-Leuchtdiode 16 erforderliche Bonddrähte 20 erfordern Bauraum und ragen insbesondere in den durch die Ebene der Oberfläche 12 begrenzten und dem Si-Substrat 10 gegenüberliegenden Halbraum hinein. Dadurch wird der minimal mögliche Abstand zwischen dem optoelektronischen Bauelement und seiner Oberfläche 12 einerseits und dem optischen Bauelement oder dem reflektierenden Objekt andererseits begrenzt. Ferner ist abhängig von der bei der Montage der SMD-Leuchtdiode 16 erzielten Präzision eine Kalibrierung des Systems erforderlich. Ein Funktionstest ist erst nach Fertigstellung des Systems bzw. des optoelektronischen Bauelements möglich.

US 2001/052 597 beschreibt eine Pixel Anordnung von Anzeigeelementen, die jeweils pro Pixel eine organische LED und ein der LED zugeordneten Lichtsensorelement umfasst.

Die Aufgabe der vorliegenden Erfindung besteht darin, ein optoelektronisches Bauelement sowie einen optischen Sensor zu schaffen, die eine Herstellung mit geringem Aufwand ermöglichen.

Diese Aufgabe wird durch ein optoelektronisches Positionsdetektor oder Drehwinkelsensor nach Anspruch 1.

Die vorliegende Erfindung schafft ein Positionsdetektor oder Drehwinkelsensor als optoelektronisches Bauelement mit einem Substrat, einer Mehrzahl von Lichtsensoren und einer Leuchtdiode mit einer lichtemittierenden Schicht aus einem organischen Material, wobei die Lichtsensoren und die Leuchtdiode monolithisch mit dem Substrat integriert sind.

Bevorzugte Ausführungsformen der Erfindung sind den abhängingen Ansprüchen zu entnehmen.

Der vorliegenden Erfindung liegt die Idee zugrunde, eine organische Leuchtdiode bzw. eine Leuchtdiode mit einer lichtemittierenden Schicht aus einem organischen Material und einen Lichtsensor monolithisch auf einem Substrat, insbesondere auf einem Halbleitersubstrat, bzw. auf einem Chip zu integrieren.

Ein Vorteil der vorliegenden Erfindung besteht darin, daß das optoelektronische Bauelement mit geringem Herstellungsaufwand und damit ohne weiteres in großen Stückzahlen herstellbar ist. Insbesondere erfordert die Herstellung des erfindungsgemäßen optoelektronischen Bauelements keine Erzeugung einer Ausnehmung, wie sie gemäß dem Stand der Technik erforderlich ist. Die Herstellung des erfindungsgemäßen optoelektronischen Bauelements erfolgt mittels bekannter und gut beherrschter Halbleitertechnologien und unter Verwendung vorhandener Vorrichtungen bzw. vorhandenen Equipments.

Die Herstellung wird dadurch vereinfacht, daß sie keine Erzeugung einer Metallisierung in einer Ausnehmung erfordert. Ferner entfallen sämtliche Prozeßschritte zum Erzeugen, Metallisieren und Passivieren einer Ausnehmung.

Zur Kontaktierung der Leuchtdiode werden vorzugsweise Leiterbahnen verwendet. Bonddrähte sind nicht erforderlich. Im Vergleich zum Stand der Technik entfallen bei der Herstellung des erfindungsgemäßen optoelektronischen Bauelements alle Arbeitsschritte zur Montage der SMD-Leuchtdiode.

Die laterale Präzision der Fertigung und der Anordnung der Leuchtdiode entspricht der Genauigkeit eines Halbleiterherstellungsprozesses. Diese liegt typischerweise unterhalb der Mikrometerskala und ist damit um einen Faktor 10 bis 100 besser als bei der herkömmlich erforderlichen Montage der SMD-Leuchtdiode, deren laterale Ortsungenauigkeit immer einige 10 µm beträgt. Ferner entfallen Schritte zur Justage oder Kalibrierung der Einbauposition der herkömmlichen SMD-Leuchtdiode 16.

Ein weiterer Vorteil der vorliegenden Erfindung besteht darin, daß die Bauhöhe einer Leuchtdiode mit einer lichtemittierenden Schicht aus einem organischen Material mit 150 nm bis 160 nm extrem klein ist. Die organische Leuchtdiode ist damit dünner als Passivierungsschichten über Leiterbahnen eines Halbleiterchips.

Ein weiterer wichtiger Vorteil der vorliegenden Erfindung besteht darin, daß das optoelektronische Bauelement vollständig auf Waferniveau bzw. vor einer Vereinzelung fertiggestellt wird. Das optoelektronische Bauelement ist deshalb im Waferverbund testbar, was eine kostengünstige Herstellung insbesondere bei großen Stückzahlen ermöglicht.

Aufgrund des Wegfalls von Bonddrähten ist das erfindungsgemäße optoelektronische Bauelement sehr flach ausführbar und kann wesentlich näher an einen Gegenstand herangeführt werden.

Ein weiterer Vorteil der vorliegenden Erfindung besteht darin, daß das erfindungsgemäße optoelektronische Bauelement ein herkömmliches optoelektronisches Bauelement ersetzen kann, ohne daß Änderungen eines übergeordneten oder nachgeschalteten Systems erforderlich sind. Die vorliegende Erfindung vermindert somit den Entwicklung- und Herstellungsaufwand signifikant.

Ein wesentlicher Aspekt der vorliegenden Erfindung ist die Kombination von Lichtsensoren, die vorzugsweise Halbleiter-Lichtsensoren sind, mit einer organischen Leuchtdiode bzw. einer Leuchtdiode mit einer lichtemittierenden Schicht aus einem organischen Material. Die vorliegende Erfindung vereinbart damit die einfache und gut beherrschte Technologie der Erzeugung von Halbleiter-Lichtsensoren, beispielsweise Photodioden, Phototransistoren oder photoresistiven Bauelementen mit den Vorteilen der einfach herzustellenden organischen Leuchtdiode.

Bevorzugte Weiterbildungen der vorliegenden Erfindung sind in den Unteransprüchen definiert.

Nachfolgend werden bevorzugte Ausführungsbeispiele der vorliegenden Erfindung mit Bezug auf die beiliegenden Figuren näher erläutert. Es zeigen:
- Fig. 1: eine schematische perspektivische Darstellung eines optoelektronischen Bauelements gemäß einem bevorzugten Ausführungsbeispiel der vorliegenden Erfindung; und
- Fig. 2: eine schematische Darstellung eines Schnitts durch ein herkömmliches optoelektronischen Bauelement.

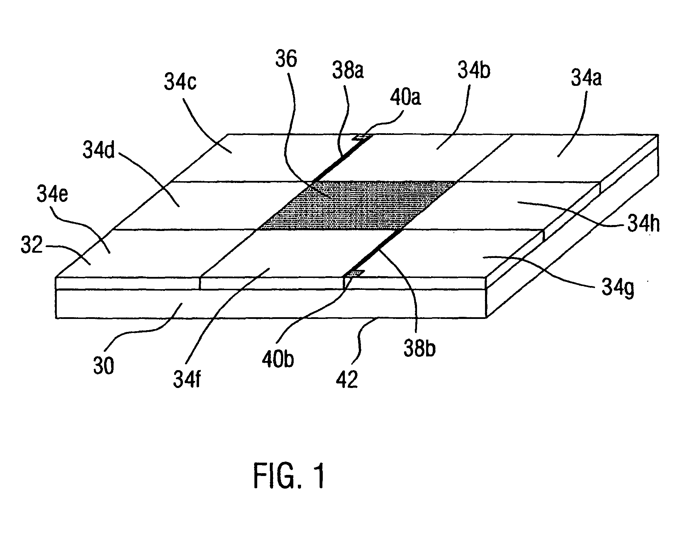

Fig. 1 ist eine schematische Darstellung einer perspektivischen Ansicht eines optoelektronischen Bauelements gemäß einem bevorzugten Ausführungsbeispiel der vorliegenden Erfindung. Ein Si-Substrat 30 weist an einer Oberfläche 32 acht Lichtsensoren 34a, ..., 34h und eine Leuchtdiode 36 auf. Die Lichtsensoren 34a, ..., 34h und die Leuchtdiode 36 weisen jeweils eine im wesentlichen rechteckige oder quadratische Form auf. Die Lichtsensoren 34a, ..., 34h und die Leuchtdiode 36 sind gitterartig in Form von drei nebeneinanderliegenden Reihen à drei Bauelementen angeordnet, wobei die Leuchtdiode 36 in der Mitte liegt und an allen Seiten von den Lichtsensoren 34a, ..., 34h umgeben ist. Die Lichtsensoren 34a, ..., 34h sind vorzugsweise Halbleiter-Lichtsensoren, beispielsweise Photodioden, Phototransistoren, photoresistive Bauelemente oder andere Photosensitive Bauelemente, die eine elektrische Eigenschaft aufweisen, die durch eingestrahltes Licht auf eine bekannte Art und Weise verändert wird.

Die Leuchtdiode 36 umfaßt eine lichtemittierende Schicht aus einem organischen Material bzw. einer organischen Verbindung. Die lichtemittierende Schicht kann Bestandteil eines Schichtstapels aus einer Mehrzahl von Schichten sein, wobei Schichten des Schichtstapels verschiedene organische Verbindungen enthalten.

Die Leuchtdiode 36 ist mittels Leiterbahnen 38a, 38b elektrisch kontaktiert. Die Leiterbahnen 38a, 38b sind jeweils zwischen zwei Lichtsensoren 34b, 34c bzw. 34f, 34g angeordnet. Die Leiterbahnen 38a, 38b verbinden die Leuchtdiode 36 mit Anschlußkontaktflächen bzw. Anschlußpads 40a, 40b, die an von der Leuchtdiode 36 abgewandten Seiten der Lichtsensoren 34c, 34g angeordnet sind. Die Anschlußkontaktflächen 40a, 40b werden beispielsweise mittels Bonddrähten kontaktiert. Alternativ führen von den Anschlußkontaktflächen 40a, 40b Durchgangslochleiter zu der von den Lichtsensoren 34a, ..., 34h und der Leuchtdiode 36 abgewandten Oberfläche 42 des Si-Substrats 30. An der Oberfläche 42 des Si-Substrats 30 sind dann vorzugsweise weitere Kontaktanschlußflächen ausgebildet, die für eine Flip-Chip-Montage des Chips bzw. des Si-Substrats 30 an einem weiteren Substrat, beispielsweise einer Leiterplatte, vorgesehen sind.

Entsprechende Leiterbahnen und Anschlußkontaktflächen sind vorzugsweise auch für die Lichtsensoren 34a, ..., 34h vorgesehen, im Sinne einer übersichtlichen Darstellung in Fig. 1 jedoch nicht gezeigt.

Ein Vorteil des erfindungsgemäßen optoelektronischen Bauelements ist, daß die Leuchtdiode 36 eine sehr geringe Bauhöhe aufweisen kann. Vorzugsweise weist sie eine Bauhöhe von ca. 150 nm bis 160 nm auf. Eine Halbleiter-Leuchtdiode weist typischerweise eine um mehrere Größenordnungen größere Bauhöhe auf und emittiert an den makroskopischen Seitenflächen Licht. Eine direkte Einstrahlung von Licht von der Halbleiter-Leuchtdiode auf die umgebenden Lichtsensoren wird beispielsweise bei dem eingangs anhand der Fig. 2 dargestellten herkömmlichen optoelektronischen Bauelement durch Anordnung der Leuchtdiode in einer Ausnehmung 14 verhindert.

Im Gegensatz dazu weist die Leuchtdiode 36 des optoelektronischen Bauelements gemäß der vorliegenden Erfindung eine so geringe Bauhöhe auf, daß sie nur sehr wenig Licht an ihren Rändern in lateraler Richtung emittiert. Eine direkte Einstrahlung von Licht von der Leuchtdiode 36 auf die Lichtsensoren 34a, ..., 34h wird ferner vorzugsweise durch eine geeignete Ausformung der Umrandung der Leuchtdiode 36 vermindert oder verhindert. Eine geeignete Ausformung der Umrandung ist beispielsweise eine Anordnung von schmalen Leiterbahnen oder entsprechenden Metallisierungsstrukturen zwischen der Leuchtdiode 36 und den benachbarten bzw. angrenzenden Lichtsensoren 34a, ..., 34h. Diese Leiterbahnen oder Metallisierungsstrukturen stellen dann eine Art von Wällen dar, die eine geradlinige Ausbreitung von Licht von der Leuchtdiode 36 zu einem der Lichtsensoren 34a, ..., 34h verhindern. Alternativ werden diese Wälle aus Halbleiteroxid gebildet oder durch eine über den Leiterbahnen aufgebrachte Passivierungsschicht weiter erhöht.

Eine alternative Anordnung zur Reduzierung von Streulicht bzw. einer direkten Einstrahlung von Licht von der Leuchtdiode 36 auf die Lichtsensoren 34a, ..., 34h ist die Anordnung der Leuchtdiode 36 in einer Vertiefung bzw. Ausnehmung in der Oberfläche 32 des Si-Substrats 30. Im Gegensatz zu dem oben anhand der Fig. 2 dargestellten herkömmlichen optoelektronischen Bauelemente ist jedoch eine wesentlich geringere Tiefe der Ausnehmung ausreichend, um eine Einstrahlung von Streulicht von der Leuchtdiode 36 auf die Lichtsensoren 34a, ..., 34h in ausreichendem Maße zu verringern. Vorzugsweise ist die Tiefe der Ausnehmung mindestens so groß wie die Bauhöhe der Leuchtdiode 36. Besonders bevorzugt beträgt die Tiefe der Ausnehmung nur wenige bis einige µm.

Das anhand der Fig. 1 dargestellte erfindungsgemäße optoelektronische Bauelement ist monolithisch bzw. einstückig integriert. Bei dem oben anhand der Fig. 2 dargestellten herkömmlichen optoelektronischen Bauelemente wird eine vollständig erzeugte und funktionsfähige Leuchtdiode 16 in die Vertiefung 14 des Substrats 10 eingesetzt. Im Gegensatz dazu wird die Leuchtdiode 36 des erfindungsgemäßen optoelektronischen Bauelements erst an der Oberfläche 32 des Si-Substrats 30 erzeugt. Dazu werden nacheinander eine oder mehrere optisch aktive bzw. lichtemittierende Schichten aus einem organischen Material bzw. einer organisch-chemischen Substanz, elektrisch leitfähige Schichten und ggf. weitere Schichten mit vorbestimmten elektrischen oder optischen Eigenschaften erzeugt. Keines der zur Bildung der Leuchtdiode 36 schichtweise auf die Oberfläche 32 des Substrats 30 aufgebrachten Materialien hat vor dem Aufbringen die Funktion oder Wirkung eine Leuchtdiode. Die Leuchtdiode 36 wird somit erst auf der Oberfläche 32 des Si-Substrats 30 erzeugt. Die Leuchtdiode 36 ist mit dem Si-Substrat 30 einstückig und untrennbar verbunden. Sie kann von dem Si-Substrat 30 nicht ohne weiteres getrennt werden, ohne ihre Funktion zu zerstören. Eine funktionserhaltende Trennung der Leuchtdiode 36 von dem Si-Substrat 30 wäre nur mit einem extremen technologischen Aufwand möglich. Beispielsweise könnte das Si-Substrat 30 durch Ätzen von der Rückseite der Leuchtdiode 36 entfernt werden. Dabei würde jedoch das Si-Substrat 30 zerstört.

Eine Anwendung für das anhand der Fig. 1 dargestellte erfindungsgemäße optoelektronische Bauelement ist ein Drehwinkelsensor zur Erfassung eines Drehwinkels. Dazu wird der Oberfläche 32 des Si-Substrats 30 gegenüber und vorzugsweise parallel zu derselben ein optisches Bauelement angeordnet. Das optische Bauelement ist starr mit einer Vorrichtung verbunden, die relativ zu dem optoelektronischen Bauelement um eine Achse drehbar ist, die vorzugsweise im wesentlichen senkrecht zu der Oberfläche 32 des Si-Substrats 30 und ferner vorzugsweise im wesentlichen in der Mitte der Leuchtdiode 36 angeordnet ist. Das optische Bauelement reflektiert, beugt oder lenkt auf andere Weise Licht von der Leuchtdiode 36 auf die Lichtsensoren 34a, ..., 34h.

Das optische Bauelement weist eine optische Eigenschaft auf, die zur Folge hat, daß nicht alle Lichtsensoren 34a, ..., 34h Licht der gleichen Intensität empfangen. Das optische Bauelement umfaßt vorzugsweise ein optisches Gitter bzw. eine Gitterstruktur, an der durch Interferenz das Licht von der Leuchtdiode 36 gebeugt wird. Das gebeugte Licht weist in verschiedenen Raumwinkelbereichen Intensitätsmaxima auf, die durch dazwischenliegende Intensitätsminima voneinander getrennt sind. Die Raumwinkelbereiche, in denen die Intensitätsmaxima auftreten und damit die Intensitätsverteilung auf den Lichtsensoren 34a, ..., 34h ist von der Winkelposition des optischen Gitters relativ zu dem optoelektronischen Bauelement abhängig. Aus den von den einzelnen Lichtsensoren 34a, ..., 34h empfangenen Lichtintensitäten kann somit auf die Winkelposition des optischen Gitters geschlossen werden.

Die Auswertung der von den Lichtsensoren 34a, ..., 34h empfangenen Lichtintensitäten bzw. der durch die Lichtsensoren 34a, ..., 34h erzeugten Meßsignale erfolgt vorzugsweise durch eine Logikschaltung, welche besonders bevorzugt ebenfalls mit den Lichtsensoren 34a, ..., 34h und der Leuchtdiode 36 auf dem Si-Substrat 30 integriert bzw. einstückig ausgeführt ist. Die Logikschaltung bestimmt aus den die empfangenen Intensitäten darstellenden Meßsignale der Lichtsensoren 34a, ..., 34h die Winkelposition des optischen Gitters relativ zu dem optoelektronischen Bauelement. Diese Winkelposition wird vorzugsweise in Form eines analogen oder digitalen elektrischen Signals ausgegeben.

Anstelle eines Beugungsgitters umfaßt das optische Bauelement alternativ eine oder mehrere andere Strukturen, welche Licht von der Leuchtdiode 36 in einer Weise auf die Lichtsensoren 34a, ..., 34h lenken, die von der Winkelposition des optischen Bauelements relativ zu dem optoelektronischen Bauelement abhängt.

Zur Erfassung einer linearen Koordinate oder einer linearen Bewegung eines Gegenstands oder eines optischen Bauelements relativ zu dem optoelektronischen Bauelement sind die Lichtsensoren und eine Leuchtdiode vorzugsweise linear angeordnet. Zur Erfassung einer Abstandskoordinate senkrecht zu der Oberfläche des Substrats aufgrund der Intensität reflektierten Lichts weist das optoelektronische Bauelement vorzugsweise einen einzigen Lichtsensor und eine einzige Leuchtdiode auf.

Zur Erfassung einfacher geometrischer Abbildungen weist das optoelektronische Bauelement vorzugsweise eine Mehrzahl von Lichtsensoren auf, die in einem Array angeordnet sind. Eine Leuchtdiode 36 ist ebenfalls in dem Array oder an dessen Rand angeordnet. Für die Erfassung einfacher geometrischer Abbildungen oder auch für andere Anwendungen ist das optoelektronische Bauelement mit einem abbildenden optischen System aus einem oder mehreren Spiegeln oder Linsen kombinierbar.

Neben Intensität und Richtung bzw. Ortsabhängigkeit der Intensität auf einem Array aus Lichtsensoren ist auch die Polarisation von Licht auswertbar, um einen Ort, eine Ausrichtung bzw. eine Winkelposition, einen Abstand, eine Größe oder eine andere Eigenschaft eines optischen Bauelements oder eines lichtreflektierenden Gegenstandes zu bestimmen.

Vorzugsweise sind die Mehrzahl von Lichtsensoren und die Leuchtdiode an ein und derselben Oberfläche eines Substrats und damit im wesentlichen koplanar angeordnet. Alternativ sind die Mehrzahl von Lichtsensoren und die Leuchtdiode an einer gekrümmten Oberfläche eines Substrats oder an zwei oder mehreren nichtparallelen Oberflächen angeordnet. Beispielsweise sind die Lichtsensoren an einer Oberfläche eines Substrats angeordnet, an der gewöhnlich Bauelemente gebildet werden, wobei die Leuchtdiode an einer seitlichen Oberfläche angeordnet ist, die im rechten Winkel zu der ersten Oberfläche angeordnet ist. Dies ist insbesondere deshalb möglich, da die lichtemittierende organische Schicht und die weiteren Schichten der Leuchtdiode unabhängig von kristallographischen Eigenschaft oder einer Schichtstruktur eines Halbleitersubstrats erzeugbar sind.

Nachfolgend wird eine Herstellung eines erfindungsgemäßen optoelektronischen Bauelements gemäß einem bevorzugten Ausführungsbeispiel beschrieben. Ausgangspunkt ist ein Si-Wafer bzw. ein Si-Substrat 30. Das Si-Substrat 30 weist die typischen Spezifikationen auf, die ein Substrat für Lichtsensoren bzw. lichtempfindliche Sensoren und für den entsprechenden Halbleiterherstellungsprozeß für die Herstellung von Lichtsensoren aufweisen muß. Vorzugsweise handelt es sich insbesondere um einen hochohmigen Si-Wafer. Alternativ ist ein beliebiges Substrat verwendbar, das vorzugsweise ein Halbleitermaterial aufweist.

Für die Erzeugung der Lichtsensoren 34a, ..., 34h und der Leuchtdiode 36 werden mittels Maskierungs- und Lithographie-Verfahren jeweils laterale Bereiche definiert.

In dem Si-Substrat 30 werden die Lichtsensoren 34a, ..., 34h entsprechend der gängigen Halbleiterfertigungstechnologie durch Implantation oder Eindiffusion von Dotierstoffen erzeugt. Der Platz für die später zu erzeugende Leuchtdiode 36 wird vorzugsweise freigelassen.

Die Erzeugung der Lichtsensoren 34a, ..., 34h des erfindungsgemäßen optoelektronischen Bauelements erfolgt vorzugsweise in CMOS-Technologie. Alternativ ist eine andere Technologie verwendbar.

Die Leuchtdiode 36 wird durch Aufbringen der entsprechenden Ausgangsmaterialien erzeugt. Insbesondere wird eine optisch aktive bzw. lichtemittierende Schicht aus einem organischen Material bzw. einer organisch-chemischen Verbindung erzeugt. Alternativ wird ein Schichtsystem aus organischen Materialien erzeugt, wobei eine oder mehrere Schichten des Schichtsystems für eine Lichtemission vorgesehen sind. Die Erzeugung der Schichten der Leuchtdiode 36 erfolgt in einer In-Line-Fertigungsanlage. Dazu wird das Si-Substrat 30 in die prozeßkompatible Fertigung für die organische Leuchtdiode 36 transferiert. Die organische Leuchtdiode bzw. die Leuchtdiode 36 mit der lichtemittierenden organischen Schicht wird in dem Freiraum an der Oberfläche 32 des Si-Substrats 30 erzeugt, der bei der Erzeugung der Lichtsensoren 34a, ..., 34h ausgespart wurde.

Erst nach der Erzeugung der Leuchtdiode 36 in der OLED-Herstellungsanlage (OLED = Organic Light Emitting Diode) wird die zur Verdrahtung der Schaltung bzw. des optoelektronischen Bauelements und zur Kontaktierung der Leuchtdiode 36 und der Lichtsensoren 34a, ..., 34h erforderliche Metallisierung aufgebracht. Die Metallisierung wird vorzugsweise durch Sputtern mittels eines entsprechenden Targets erzeugt. Die Erzeugung der Metallisierung stellt somit einen der letzten Arbeitsschritte dar. Die Metallisierung wird durch ein geeignetes Ätzverfahren lateral strukturiert, um Verdrahtungsleiterbahnen zu erzeugen.

Der fertige Schaltkreis bzw. das fertige optoelektronische Bauelement wird mit einer Dünnschichtpassivierung versehen. Die Passivierung wird an den vorgesehenen Stellen geöffnet, um Anschlußkontaktflächen zu bilden. Alternativ wird die Passivierung mittels einer sogenannten Schattenmaske direkt aufgebracht.

Die beschriebene Herstellung erfolgt vorzugsweise auf Waferlevel bzw. Waferebene. Noch vor dem Vereinzeln des Wafers in einzelne optoelektronische Bauelemente erfolgt eine Testung der fertigen Schaltkreise im Waferverbund. Diese Testung erfolgt vorzugsweise nach Standardverfahren auf einem herkömmlichen Waferprober. Dabei werden die optoelektronischen Bauelemente des Wafers mittels sogenannter Nadelkarten kontaktiert. Das erfindungsgemäße optoelektronische Bauelement ist im Gegensatz zu dem eingangs anhand der Fig. 2 beschriebenen herkömmlichen optoelektronischen Bauelemente nicht erst nach Vereinzeln und Bonden sondern bereits vor dem Vereinzeln, also noch im Waferverbund, vollständig und vollständig funktionsfähig. Das erfindungsgemäße optoelektronische Bauelement wird deshalb vorzugsweise hinsichtlich seiner gesamten Funktionalität vollständig getestet, d. h. neben seinen elektrischen Eigenschaften werden auch die optischen bzw. elektrooptischen Eigenschaften jedes einzelnen optoelektronischen Bauelements des Wafers erfaßt bzw. vermessen. Dazu werden vorzugsweise optische Bauelemente bzw. entsprechende Muster oder Strukturen den optoelektronischen Bauelementen des Wafers gegenüber angeordnet.

Nach dem Test der optoelektronischen Bauelemente des Wafers werden fehlerhafte optoelektronische Bauelemente durch Markieren bzw. Inken gekennzeichnet oder in einer Wafermap eingetragen und unmittelbar nach dem Vereinzeln ausgesondert.

### Bezugszeichenliste

- 10: Si-Substrat
- 12: Oberfläche des Si-Substrats
- 14: Ausnehmung
- 16: SMD-Leuchtdiode
- 18: lichtempfindliche Diode
- 20: Bonddraht
- 22: Leiterbahn
- 30: Si-Substrat
- 32: Oberfläche des Si-Substrats 30
- 34a, ... , 34h: Lichtsensor
- 36: Leuchtdiode
- 38a, 38b: Leiterbahn
- 40a, 40b: Anschlußkontaktfläche
- 42: Oberfläche des Si-Substrats 30

## Patentansprüche

1. Optoelektronischer Positionsdetektor oder Drehwinkelsensor, mit:
einem Substrat (30);
einer Leuchtdiode (36) mit einer lichtemittierenden Schicht aus einem organischen Material;
einer Mehrzahl von Lichtsensoren (34a, ..., 34h, die lateral benachbart zu der Leuchtdiode (36) angeordnet sind,
wobei die Lichtsensoren (34a, ..., 34h) und die Leuchtdiode (36) monolithisch mit dem Substrat (30) integriert sind; und
einem gegenüber dem Substrat (30) bezüglich der zu erfassenden Position oder des zu erfassenden Winkels angeordneten optischen Bauelement, das den Lichtsensoren (34a, ..., 34h) und der Leuchtdiode (36) gegenüberliegend angeordnet ist, zum Lenken von Licht, das von der Leuchtdiode (36) emittiert wird, zu den Lichtsensoren (34a, ..., 34h), wobei die Intensität, die Richtung oder die Polarisation des von den Lichtsensoren (34a, ..., 34h) empfangenen Lichts von dem Ort oder der Ausrichtung des optischen Bauelements abhängig ist.

2. Optoelektronischer Positionsdetektor oder Drehwinkelsensor nach Anspruch 1, bei dem die Lichtsensoren (34a, ...,34h) und die Leuchtdiode (36) an einer Oberfläche (32) des Substrats (30) angeordnet sind.

3. Optoelektronischer Positionsdetektor oder Drehwinkelsensor nach Anspruch 2, ferner mit
einer Leiterbahn (38a, 38b) zum Kontaktieren der Lichtsensoren (34a, ..., 34h) oder der Leuchtdiode (36); und
einer Passivierungsschicht, die einen Teil der Leiterbahn bedeckt.

4. Optoelektronischer Positionsdetektor oder Drehwinkelsensor nach Anspruch 3, bei dem die lichtemittierende Schicht der Leuchtdiode dünner als die Passivierungsschicht ist.

5. Optoelektronischer Positionsdetektor oder Drehwinkelsensor nach einem der Ansprüche 1 bis 4, bei dem die Lichtsensoren (34a, ..., 34h) zum Empfangen eines Lichtsignals vorgesehen sind, das von der Leuchtdiode (36) erzeugt und von einem optischen Gitter zur Beugung von Licht mittels Interferenz zu den Lichtsensoren (34a, ..., 34h) gelenkt wird.

6. Optoelektronischer Positionsdetektor oder Drehwinkelsensor nach einem der Ansprüche 1 bis 5, bei dem die Lichtsensoren (34a, ..., 34h) eine Photodiode oder einen Phototransistor umfassen.

7. Optoelektronischer Positionsdetektor oder Drehwinkelsensor nach einem der Ansprüche 1-6, bei dem die Leuchtdiode (36) in einer Ausnehmung in der Oberfläche (32) des Substrats (30) angeordnet ist, wodurch eine Einstrahlung von Streulicht von der Leuchtdiode (36) zu den Lichtsensoren reduziert oder verhindert wird.

8. Optoelektronischer Positionsdetektor oder Drehwinkelsensor nach einem der Ansprüche 1-7, bei dem die Leuchtdiode mit einer Umrandung versehen ist, wodurch eine Einstrahlung von Streulicht von der Leuchtdiode (36) zu den Lichtsensoren reduziert oder verhindert wird.

## Claims

1. Opto-electronic position detector or angle of rotation sensor, comprising:
a substrate (30);
a light-emitting diode (36) having a light-emitting layer of an organic material;
a plurality of light sensors (34a, ..., 34h) arranged laterally adjacent to the light-emitting diode (36),
wherein the light sensors (34a, ..., 34h) and the light-emitting diode (36) are monolithically integrated with the substrate (30); and
an optical device arranged opposite the substrate (30) with respect to the position or angle to be detected and arranged opposite the light sensors (34a, ..., 34h) and the light-emitting diode (36) for directing light emitted from the light-emitting diode (36) to the light sensors (34a, ..., 34h), wherein the intensity, the direction or the polarization of the light received from the light sensors (34a, ..., 34h) is dependent on the location or the alignment of the optical device.

2. Opto-electronic position detector or angle of rotation sensor according to claim 1, wherein the light sensors (34a, ..., 34h) and the light-emitting diode (36) are arranged at a surface (32) of the substrate (30).

3. Opto-electronic position detector or angle of rotation sensor according to claim 2, further comprising
a conductive trace (38a, 38b) for contacting the light sensors (34a, ..., 34h) or the light-emitting diode (36); and
a passivation layer covering a part of the conductive trace.

4. Opto-electronic position detector or angle of rotation sensor according to claim 3, wherein the light-emitting layer of the light-emitting diode is thinner than the passivation layer.

5. Opto-electronic position detector or angle of rotation sensor according to one of claims 1 to 4, wherein the light sensors (34a, ..., 34h) are provided for receiving a light signal which is generated by the light-emitting diode (36) and directed from an optical grating for diffracting light by means of interference to the light sensors (34a, ..., 34h).

6. Opto-electronic position detector or angle of rotation sensor according to one of claims 1 to 5, wherein the light sensors (34a, ..., 34h) include a photodiode or a phototransistor.

7. Opto-electronic position detector or angle of rotation sensor according to one of claims 1 to 6, wherein the light-emitting diode (36) is arranged in a recess in the surface (32) of the substrate (30) whereby a radiation of scattered light from the light-emitting diode (36) to the light sensors is reduced or prevented.

8. Opto-electronic position detector or angle of rotation sensor according to one of claims 1 to 7, wherein the light-emitting diode is provided with a border, whereby a radiation of scattered light from the light-emitting diode (36) to the light sensors is reduced or prevented.

## Revendications

1. Détecteur de position ou capteur d'angle de rotation optoélectronique, avec :
un substrat (30) ;
une diode luminescente (36) avec une couche luminescente en un matériau organique ;
une pluralité de capteurs de lumière (34a, ..., 34h) qui sont disposés latéralement adjacents à la diode luminescente (36),
les capteurs de lumière (34a, ..., 34h) et la diode luminescente (36) étant intégrés de manière monolithique avec le substrat (30) ; et
un composant optique, disposé face au substrat (30) par rapport à la position à détecter ou à l'angle à détecter, qui est disposé face aux capteurs de lumière (34a, ..., 34h) et à la diode luminescente (36), destiné à dévier vers les capteurs de lumière (34a, ..., 34h) la lumière qui est émise par la diode luminescente (36), l'intensité, la direction ou la polarisation de la lumière reçue par les capteurs de lumière (34a, ..., 34h) étant fonction de l'emplacement ou de l'orientation du composant optique.

2. Détecteur de position ou capteur d'angle de rotation optoélectronique selon la revendication 1, dans lequel les capteurs de lumière (34a, ...,34h) et la diode luminescente (36) sont disposés sur une surface (32) du substrat (30).

3. Détecteur de position ou capteur d'angle de rotation optoélectronique selon la revendication 2, avec par ailleurs
un chemin de conducteurs (38a, 38b) pour la mise en contact des capteurs de lumière (34a, ..., 34h) ou de la diode luminescente (36) ; et
une couche de passivation qui recouvre une partie du chemin de conducteurs.

4. Détecteur de position ou capteur d'angle de rotation optoélectronique selon la revendication 3, dans lequel la couche luminescente de la diode luminescente est plus mince que la couche de passivation.

5. Détecteur de position ou capteur d'angle de rotation optoélectronique selon l'une des revendications 1 à 4, dans lequel les capteurs de lumière (34a, ..., 34h) sont prévus pour recevoir un signal lumineux qui est généré par la diode luminescente (36) et dévié vers les capteurs de lumière (34a, ..., 34h) par une grille optique de diffraction de lumière par interférence.

6. Détecteur de position ou capteur d'angle de rotation optoélectronique selon l'une des revendications 1 à 5, dans lequel les capteurs de lumière (34a, ..., 34h) comprennent une photodiode ou un phototransistor.

7. Détecteur de position ou capteur d'angle de rotation optoélectronique selon l'une des revendications 1 à 6, dans lequel la diode luminescente (36) est disposée dans un évidement dans la surface (32) du substrat (30), d'où un rayonnement de lumière diffuse de la diode luminescente (36) vers les capteurs de lumière est réduit ou empêché.

8. Détecteur de position ou capteur d'angle de rotation optoélectronique selon l'une des revendications 1 à 6, dans lequel la diode luminescente est pourvue d'un rebord, d'où un rayonnement de lumière diffuse de la diode luminescente (36) vers les capteurs de lumière est réduit ou empêché.
